# FASCICULE DE BREVET EUROPEEN

(11) **EP 2 503 596 B1**
(45) Date de publication et mention de la délivrance du brevet: **18.12.2013**
(21) Numéro de dépôt: 12160048.0
(22) Date de dépôt: 19.03.2012
(51) Int. Cl.: H01L 27/146, H04N 5/351, H04N 5/3745

(54) **Capteur d'image à multiplication d'electrons**
Elektronenvervielfachungs Bildgeber
Electron multiplication imaging device

(30) Priorité: 23.03.2011 FR 1152413
(43) Date de publication de la demande: 26.09.2012
(73) Titulaire: E2V Semiconductors, 38120 Saint Egreve (FR)
(72) Inventeur: Fereyere, Pierre, 38340 Voreppe (FR); Mayer, Frédéric, 38500 Voiron (FR)
(74) Mandataire: Guérin, Michel

(56) Documents cités:
- EP-A1- 2 071 628
- EP-A2- 2 107 610
- US-A1- 2008 179 495
- US-A1- 2009 284 632

## Description

L'invention concerne les capteurs d'image, et plus particulièrement ceux qui sont destinés à recueillir des images à bas niveau de luminance et éventuellement aussi à haut niveau de luminance.

Lorsque le niveau de lumière est faible, les pixels d'un capteur d'image matriciel recueillent peu d'électrons ; on est obligé d'augmenter beaucoup la durée d'intégration pour obtenir une image, mais c'est au détriment du rapport signal sur bruit.

En technologie CCD (Charge-Coupled Devices) on a déjà proposé d'incorporer au capteur des systèmes de multiplication d'électrons qui créent des électrons supplémentaires à partir des électrons générés naturellement par la lumière. Le signal électrique qui est recueilli ensuite est donc multiplié par un coefficient. Le bruit augmente aussi mais dans un rapport plus faible que le signal.

Ces principes de multiplication d'électrons en technologie CCD consistent à augmenter les différences de potentiel présentes entre les grilles de transfert de charges, ce qui accélère les électrons en cours de transfert ; l'énergie qui leur est conférée est suffisante pour que les impacts avec les atomes du matériau semiconducteur fassent passer des électrons de ces atomes de la bande de valence à la bande de conduction. Ces électrons créent des paires électron-trou ; ces porteurs de charge sont eux-mêmes accélérés et peuvent donner lieu à d'autres impacts. Il en résulte un phénomène de multiplication d'électrons.

Dans les capteurs CCD on peut le faire car les électrons sont transférés de grille en grille et c'est l'augmentation de la tension sur certaines grilles qui permet d'accélérer fortement les électrons pour provoquer cette multiplication.

Mais dans les capteurs à pixels actifs, comprenant au sein de chaque pixel un circuit (quelques transistors) de conversion charge-tension, ce n'est pas possible car les paquets d'électrons sont convertis en tension immédiatement après chaque période d'intégration. Ils ne sont pas transférés de grille en grille. On a cependant déjà proposé des capteurs à pixels actifs qui utilisent un étage de multiplication à plusieurs grilles entre une photodiode et un noeud de stockage de charges, à l'intérieur du pixel. Le document US 2008/179495 décrit un capteur à pixels actifs. Cependant cet étage engendre des pertes dues notamment à la mauvaise qualité du transfert de charges dans les grilles de multiplication, sauf si ces grilles se recouvrent mutuellement mais alors cela oblige à utiliser une technologie plus coûteuse à au moins deux niveaux de grilles.

L'invention propose un capteur d'image qui utilise des pixels actifs et qui permet quand même une multiplication d'électrons dans le but de fournir des images satisfaisantes même en présence de très bas niveau de lumière ; ce capteur n'utilise pas un double niveau de grilles.

Le capteur est formé dans un substrat semiconducteur, chaque pixel comprenant, à la surface d'une couche active semiconductrice, une région de photodiode, un noeud de stockage de charges, un transistor de lecture des charges stockées dans le noeud de stockage, un transistor de réinitialisation du potentiel du noeud de stockage, et une structure de transfert pour transférer des charges de la photodiode vers le noeud de stockage après une durée d'intégration de charges générées par la lumière dans la photodiode, **caractérisé en ce que** la structure de transfert comprend une première grille de transfert adjacente à la photodiode, une deuxième grille de transfert adjacente au noeud de stockage, et une structure d'amplification située entre la première et la deuxième grille de transfert et comprenant deux grilles d'accélération séparées, une région de diode intermédiaire à potentiel superficiel fixe située entre les deux grilles d'accélération, des moyens pour appliquer d'abord à la première grille de transfert une première impulsion de transfert permettant le transfert de charges de la grille de transfert vers au moins une première grille d'accélération, des moyens pour appliquer ensuite aux grilles d'accélération une succession d'alternances de potentiels hauts et bas permettant des transferts successifs de charges d'une grille d'accélération à l'autre à travers la région de diode intermédiaire, et des moyens pour appliquer ensuite à la deuxième grille de transfert une deuxième impulsion de transfert permettant le transfert de charges des grilles d'accélération vers le noeud de stockage.

La région de diode intermédiaire est de préférence une diode dite "pinned", c'est-à-dire une diode ayant un potentiel de surface fixé par rapport à un potentiel de référence. Le potentiel de surface fixe est obtenu en plaçant la partie supérieure de la diode en contact direct avec une région semiconductrice au potentiel du substrat. Les alternances de potentiels opposés sont alors des potentiels de grille (un potentiel haut et un potentiel bas) tels que le potentiel sous la grille alterne entre un niveau plus élevé et un niveau moins élevé que le potentiel fixe de surface..

Dans tout ce qui suit, on considérera que les charges engendrées par la lumière et stockées pour être mesurées par les pixels sont des électrons, et par conséquent les potentiels les plus élevés créent des puits de potentiel pouvant recueillir des charges tandis que les potentiels plus bas créent des barrières de potentiel empêchant les transferts de charges. On pourrait envisager que les charges stockées soient des trous plutôt que des électrons ; les principes seraient les mêmes mais il faudrait inverser les potentiels ainsi que les types de conductivité des régions semiconductrices. On décrira l'invention uniquement à propos de stockage d'électrons.

Le substrat semiconducteur comporte une couche active semiconductrice de type P qui est maintenue à un potentiel de référence. La diode intermédiaire comprend une région diffusée de type N dans cette couche, et cette région est recouverte d'une région superficielle de type P qui est reliée au potentiel de la couche active. La photodiode est de préférence aussi une photodiode "pinned" constituée par une diffusion de type N recouverte par une région de type P portée au potentiel de la couche active (les dopages n'étant pas forcément les mêmes pour la diode intermédiaire et pour la photodiode). Les grilles de transfert et les grilles d'accélération sont des grilles isolées de la couche active de type P par une fine couche isolante. La région de diode intermédiaire peut être recouverte d'une couche isolante.

De préférence, la première grille de transfert est séparée de la première grille d'accélération par une distance la plus faible possible et en tous cas plus faible que la distance entre les deux grilles d'accélération. De même, la deuxième grille de transfert est séparée de la deuxième grille d'accélération par une distance la plus faible possible et plus faible que la distance entre les deux grilles d'accélération.

Le capteur peut fonctionner soit en mode sans amplification soit en mode avec amplification soit encore en mode mixte, le mode mixte permettant une très grande dynamique aussi bien du côté des éclairements très faibles que du côté des éclairements forts.

Dans le mode sans amplification, il n'y a pas d'application d'une succession de multiples alternances de potentiels haut et bas aux grilles d'accélération ; la première impulsion de transfert transfère les charges de la photodiode vers les grilles d'accélération, et la deuxième impulsion de transfert transfère les charges des grilles d'accélération vers le noeud de stockage.

Dans le mode avec amplification on applique une succession d'alternances de potentiels opposés aux grilles entre la première et la deuxième impulsions de transfert.

Dans le mode mixte, on peut prévoir qu'une trame d'image sur deux subit une amplification par une succession d'alternances de potentiels sur les grilles d'accélération avec un premier coefficient d'amplification et que l'autre trame subit une amplification avec un deuxième coefficient (ou ne subit pas du tout d'amplification : coefficient égal à 1). Le traitement ultérieur d'image utilisera pour chaque pixel la mesure provenant de l'une ou l'autre des trames selon un critère d'éclairement du pixel ou de l'image.

Alternativement, on peut également prévoir une autre solution pour fonctionner en mode mixte ; la mesure avec les deux facteurs de multiplication se fait au cours d'une même trame en décomposant en deux parties le temps d'intégration au cours de la trame, la première mesure résultant d'une première durée d'intégration et la deuxième mesure résultant d'une deuxième durée d'intégration. Le capteur comporte alors des moyens pour effectuer les groupes d'opérations suivantes :
- un premier transfert d'électrons de la photodiode vers la structure d'amplification au bout de la première durée d'intégration, une multiplication avec un premier facteur de multiplication dans la structure d'amplification, une réinitialisation du potentiel du noeud de stockage et un échantillonnage ultérieur de ce potentiel dans le circuit de lecture, un premier transfert d'électrons de la structure d'amplification vers le noeud de stockage après multiplication par le premier facteur de multiplication, et un échantillonnage du potentiel du noeud de stockage après ce transfert,
- après le premier transfert de la structure d'amplification vers le noeud de stockage, un deuxième transfert d'électrons de la photodiode vers la structure d'amplification au bout de la deuxième durée d'intégration, une multiplication avec un deuxième facteur, un deuxième transfert de charges de la structure d'amplification vers le noeud de stockage, et un échantillonnage du potentiel du noeud de stockage,
- une conversion analogique-numérique d'au moins une différence entre un échantillon pris après un transfert d'électrons vers le noeud de stockage et un échantillon pris entre la réinitialisation du noeud de stockage et ce transfert.

Les deux durées d'intégration sont de préférence différentes, la durée la plus courte correspondant de préférence au facteur de multiplication le plus faible.

Dans une réalisation, on prévoit que les premières grilles d'accélération d'une même ligne de pixels (ou respectivement d'une même colonne) sont toutes connectées entre elles, et les deuxièmes grilles d'accélération d'une même colonne (ou respectivement d'une même ligne) sont toutes connectées entre elles. Les colonnes et les lignes de grilles sont adressables, de sorte qu'on peut effectuer une amplification par alternance de potentiels des grilles dans une région d'intérêt du capteur par sélection des lignes et colonnes correspondant à cette région d'intérêt. Les pixels qui n'appartiennent pas à la fois à une telle ligne et une telle colonne ne subissent pas l'amplification d'électrons car ils ne voient pas une alternance de potentiels opposés sur leurs deux grilles d'accélération bien que l'une des grilles subisse une alternance de potentiels.

D'autres caractéristiques et avantages de l'invention apparaîtront à la lecture de la description détaillée qui suit et qui est faite en référence aux dessins annexés dans lesquels :
- la figure 1 représente en coupe verticale la structure générale d'un pixel d'un capteur d'image à pixels actifs ;
- la figure 2 représente en coupe verticale la structure d'un pixel modifié selon l'invention ;
- la figure 3 représente une vue de dessus du pixel ;
- la figure 4 représente un diagramme des potentiels dans le semiconducteur au cours des différentes étapes du fonctionnement ;
- la figure 5 représente un chronogramme de fonctionnement du capteur pour une vision à bas niveau de luminance ;
- la figure 6 représente un chronogramme de fonctionnement du capteur pour une vision à la fois à bas niveau et à haut niveau de luminance.

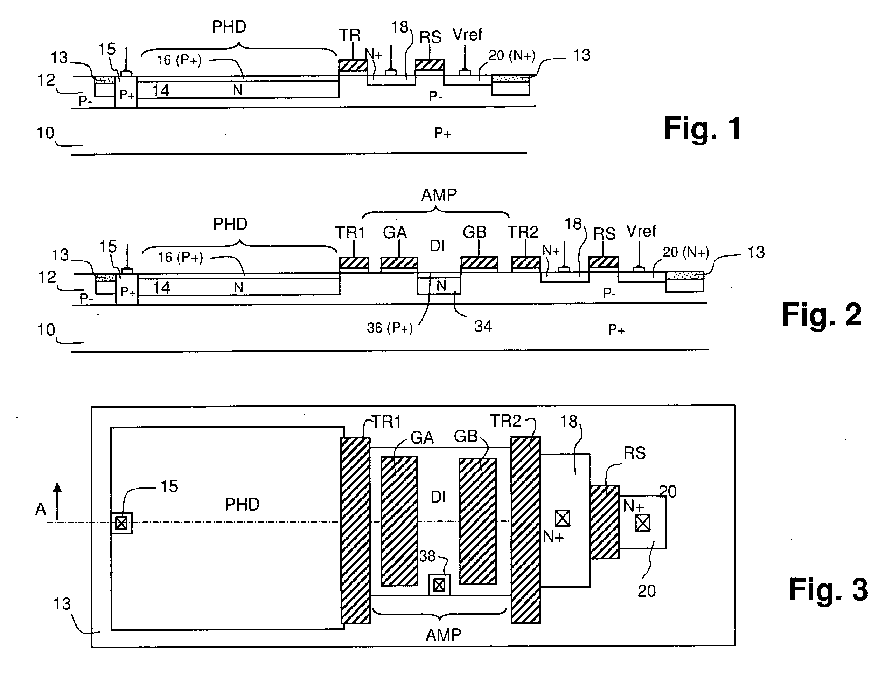

Sur la figure 1 on a représenté les éléments principaux d'un pixel actif de technologie CMOS classique. Le pixel est formé dans un substrat 10 qui comprend de préférence une couche active semiconductrice 12 de type P peu dopée ou P- (le symbole P- est utilisé pour désigner ce faible dopage) formée à la surface d'une couche plus dopée (P+). Le pixel est isolé des pixels voisins par une barrière isolante 13 qui l'entoure complètement. Cette barrière peut être une tranchée isolante superficielle au-dessus d'un caisson de type P.

Le pixel comprend une région de photodiode PHD dont le périmètre suit le contour d'une région semiconductrice de type N implantée dans une partie de la profondeur de la couche active 12. Cette région implantée est surmontée par une région superficielle 16 de type P+, qui est maintenue à un potentiel de référence zéro. Il s'agit d'une photodiode dite "pinned" (d'après le mot anglais signifiant "épinglé", qui rappelle que le potentiel de surface de la région superficielle P+ est fixé). Le potentiel de référence zéro est celui qui est appliqué à la couche active P-. Dans le cas le plus simple, c'est le potentiel du substrat de type P+ situé sous la couche active et appliquant son propre potentiel à la couche active ; le maintien de la région superficielle 16 à ce potentiel zéro est réalisé par exemple par le fait que la région 16 touche une diffusion profonde 15 de type P+ qui rejoint le substrat 10. Un contact électrique peut aussi être prévu sur cette diffusion 15 pour appliquer par ce contact un potentiel zéro à la région 16.

Une région de stockage de charges, ou noeud de stockage de charges, 18 est prévue en dehors de la région de photodiode PHD ; elle en est séparée par une grille isolée TR qui permet d'autoriser ou d'interdire un transfert des charges stockées dans la photodiode vers le noeud de stockage.

Le noeud de stockage de charges 18 est une diffusion de type N dans la couche active 12. Un contact est formé sur le noeud de stockage, pour permettre d'appliquer le potentiel de cette région sur la grille d'un transistor suiveur non représenté, afin de transformer en niveau de tension électrique la quantité de charges contenue dans le noeud de stockage.

Une autre grille RS, appelée grille de réinitialisation, permet de vider les charges du noeud de stockage vers un drain d'évacuation 20 qui est une région de type N+ reliée à un potentiel de réinitialisation positif Vref.

Pour simplifier, on n'a pas représenté des éléments qui peuvent être classiquement présents dans le pixel et notamment un transistor suiveur pour recopier le potentiel du noeud de stockage 18, et un transistor de sélection de ligne, dans le cas d'une matrice de plusieurs lignes de pixels, pour autoriser la connexion de la source du transistor suiveur à un conducteur de colonne de la matrice. Ces éléments sont de toute façon situés en dehors de la région d'isolation 13 qui entoure la photodiode. N'est pas représentée non plus sur la coupe de la figure 1 une grille de réinitialisation du potentiel de la photodiode PHD. Cette grille permet de déverser dans un drain non représenté les charges de la photodiode au début d'une durée d'intégration.

Le pixel fonctionne en général de la manière suivante : l'éclairement de la région de photodiode PHD pendant une durée d'intégration T génère des charges électriques (des électrons dans le cas présent mais ce pourrait être des trous si on inversait tous les types de conductivité et les signes des différences de potentiel appliquées). Ces charges sont stockées dans la région N de la photodiode. Avant la fin de la durée T, le potentiel du noeud de stockage est réinitialisé à Vref par la grille de réinitialisation RS. A la fin de la durée T, une impulsion de transfert est appliquée à la grille TR et les charges stockées dans la photodiode viennent se déverser dans le noeud de stockage. Le potentiel du noeud de stockage est transmis au transistor suiveur non représenté, pendant qu'une nouvelle durée d'intégration commence.

Selon l'invention, on prévoit d'incorporer une structure de multiplication d'électrons à deux grilles d'accélération dans la structure de transfert qui permet de transférer des charges de la photodiode vers le noeud de stockage 18.

La structure de pixel qui en résulte est représentée en coupe sur la figure 2 et en vue de dessus sur la figure 3.

D'abord, la grille de transfert est maintenant décomposée en deux grilles de transfert qui sont une grille de transfert amont TR1 et une grille de transfert aval TR2.

Ensuite, entre les grilles de transfert TR1 et TR2 on a placé une structure d'amplification AMP qui comprend deux grilles d'accélération GA et GB séparées par un intervalle. Cet intervalle est occupé par une région de diode intermédiaire DI, et cette région constitue une diode dite "pinned", comme la photodiode. Elle est donc constituée comme la photodiode (mais pas obligatoirement avec les mêmes dopages), par une région diffusée 34 de type N dans la couche active 12, cette région étant recouverte par une région superficielle 36 de type P+. Cette région 36 est maintenue au potentiel de référence zéro par exemple par le fait qu'elle touche, ce qu'on ne voit pas sur la figure 2, une région profonde 38 de type P+ rejoignant le substrat, analogue à la région 15 qui touche la région 16 de la photodiode.

La grille d'accélération GA est une grille isolée comme les grilles de transfert ; elle est séparée de la première grille de transfert amont TR1 par un intervalle étroit (le plus étroit possible compte-tenu de la technologie utilisée) qui peut ne pas être dopé, c'est-à-dire qui peut être constitué directement par la couche 12. De même, la grille d'accélération GB est séparée de la deuxième grille de transfert TR2 par un intervalle le plus étroit possible.

La structure de transfert (grilles TR1, TR2, grilles GA, GB, et région de diode intermédiaire) est de préférence masquée de la lumière par une couche opaque, absorbante ou réfléchissante, non représentée sur les figures.

Des moyens de commutation de potentiel sont prévus pour appliquer directement aux grilles d'accélération GA et GB des potentiels hauts ou bas selon la phase de transfert ou d'amplification concernée. Ces moyens de commutation ne sont pas représentés car ils ne sont pas situés dans le pixel.

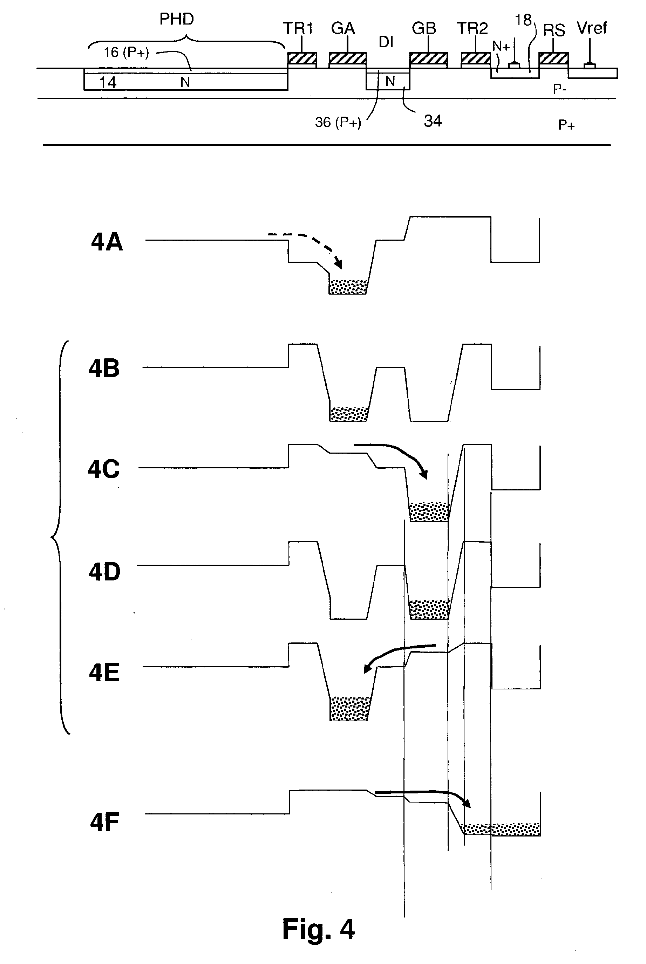

La figure 4 représente les diagrammes de potentiel dans la couche active 12, expliquant le principe de fonctionnement du capteur. On a reporté la coupe du capteur en haut de la figure pour montrer les endroits où se situent les puits et barrières de potentiel au cours des différentes étapes schématisées par les lignes 4A à 4F. Les potentiels sont classiquement représentés croissants vers le bas.

La ligne 4A représente les potentiels à la fin d'une étape d'intégration de charges, au moment du transfert de charges de la photodiode PHD vers la structure d'amplification. Ce transfert est commandé par la grille TR1, en abaissant la barrière de potentiel sous cette grille. Les charges se déversent sous la grille GA portée à ce moment à un potentiel haut. La grille GB est au potentiel bas mais pourrait aussi être au potentiel haut. La diode intermédiaire DI est au potentiel dit potentiel de construction (en anglais "buit-in potential") fixé par le maintien de la région 36 au potentiel de référence de la couche active 12, ici celui du substrat 10. Le potentiel de construction de la diode intermédiaire peut être légèrement différent du potentiel de construction de la photodiode.

Après ce premier transfert on procède à une phase d'amplification de charges. Cette phase comprend une multiplicité (plusieurs dizaines, centaines, ou même milliers) d'alternances de potentiel indiquées aux lignes 4B à 4F. Les charges confinées sous la grille GA sont d'abord basculées vers la grille GB (étapes 4B et 4C) puis à nouveau vers la grille GA (étapes 4D et 4E). Le basculement se fait avec des potentiels établissant un champ électrique fort. Sous l'effet de l'accélération des porteurs, des paires électron-trou, et donc des électrons supplémentaires, sont générés à chaque basculement. Le gain lors d'un basculement est très faible mais est multiplié par le nombre de basculements. La série d'étapes 4B à 4E est répétée N fois pour obtenir un coefficient d'amplification final désiré. Le nombre N dépend bien sûr des potentiels appliqués aux grilles GA et GB, car les champs électriques dépendent de ces potentiels et le nombre d'électrons créés par impact lors d'une étape d'application d'un champ électrique dépend du champ électrique exercé sur les électrons en transit.

Plus précisément,
- à l'étape 4B, on abaisse la barrière de potentiel sous la grille GB et on crée un puits de potentiel sous cette grille, GA restant au potentiel haut ;
- à l'étape 4C, on diminue le potentiel de la grille GA, ce qui entraîne le basculement des charges de la grille GA vers la grille GB ;
- à l'étape 4D, on crée un puits de potentiel sous la grille GA ;
- à l'étape 4E, on diminue le potentiel de la grille GB, déversant les charges de la grille GB vers la grille GA.

Les grilles GA et GB voient donc une alternance de champs électriques opposés, le potentiel de l'une des grilles créant sous cette grille une barrière de potentiel plus haute que le potentiel de construction de la diode intermédiaire DI et le potentiel sous l'autre grille créant sous cette grille un puits de potentiel plus profond que le potentiel de construction de la diode intermédiaire.

Au bout de N séries d'alternances, on s'arrête à l'étape 4C, et on procède à un transfert de charges sous la deuxième grille de transfert vers le noeud de stockage 18.

L'étape 4F représente ce transfert final : on diminue le potentiel de la grille GA (celui de la grille GB reste haut), et on augmente le potentiel de la grille de transfert TR2 (celui de la grille TR1 est bas et reste bas). Les charges présentes sous la grille GB se déversent vers le noeud de stockage. Elles se concentrent dans ce noeud lorsque la grille de transfert TR2 est refermée par abaissement de son potentiel.

La largeur de la diode intermédiaire DI, c'est-à-dire la distance entre les grilles d'accélération, est suffisamment grande pour que le potentiel dans le semi-conducteur reste fixe au moins au centre de la diode. Si elle était trop étroite, le potentiel subirait l'influence des grilles adjacentes.

La région de diode intermédiaire ne sert à aucun moment à stocker des charges, contrairement aux régions situées au-dessous des grilles d'accélération. Elle est une région de transit pour les charges qui se déplacent de la région sous la grille GA à la région sous la grille GB.

La région P+ 36 peut être recouverte d'une fine couche isolante. Cette couche isolante n'est pas dégradée par les électrons accélérés d'une grille à l'autre car le transit se fait en volume sous la région 36 et non en surface.

On va maintenant décrire différents modes de fonctionnement possibles de cette structure de capteur d'image.

De manière générale, le pixel fait partie d'une matrice de pixels en lignes et en colonne, les pixels d'une même ligne sont adressés par un conducteur de ligne, et les sorties des pixels d'une même colonne sont reliées à un conducteur de colonne. Un circuit de lecture par double échantillonnage est placé en pied de colonne et permet d'échantillonner les potentiels qui apparaissent sur le conducteur de colonne lors de la sélection d'une ligne de pixels. Le potentiel apparaissant sur le conducteur de colonne correspond au potentiel du noeud de stockage, qui peut être un potentiel de réinitialisation ou un potentiel de signal utile correspondant à l'éclairement du pixel sélectionné. Le circuit de lecture échantillonne et conserve en mémoire un potentiel de réinitialisation et un potentiel utile ; il détermine la différence et la convertit en numérique.

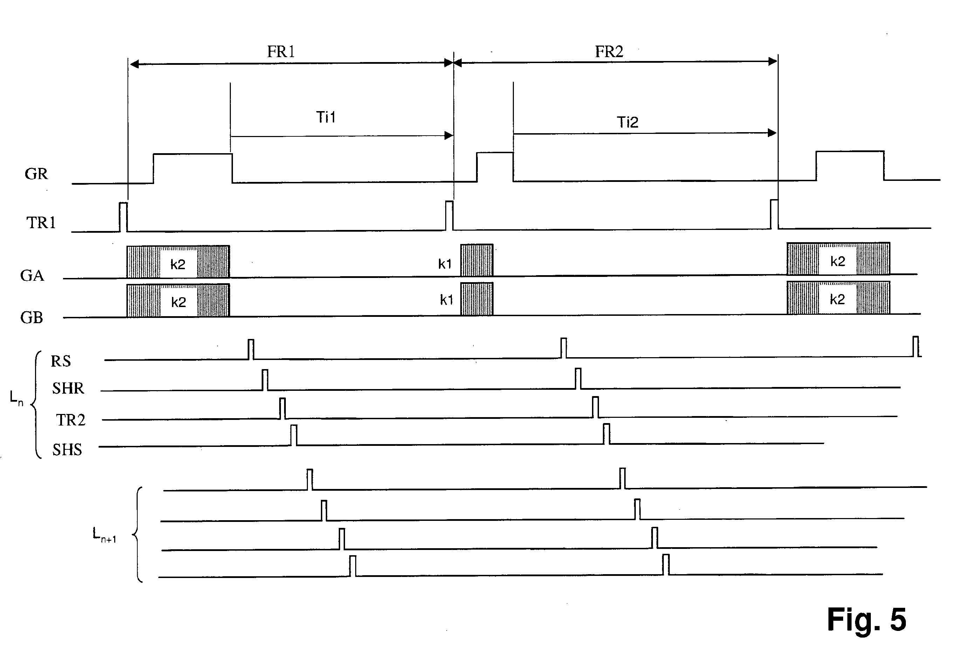

Le chronogramme de la figure 5 représente un mode de fonctionnement du capteur à bas niveau de lumière, par exemple en vision de nuit.

Deux trames successives FR1 et FR2 sont représentées sur la figure 5.

Le signal GR représente une réinitialisation du potentiel de la photodiode en début de trame, globale pour tous les pixels, réalisée par exemple par une ouverture de la grille de réinitialisation de la photodiode mentionnée plus haut.

Le signal RS représente une impulsion de réinitialisation du potentiel du noeud de stockage. Il est émis successivement pour chaque ligne au moment de la lecture.

Les signaux d'échantillonnage en pied de colonne sont désignés par SHR (échantillonnage d'un niveau de réinitialisation du noeud de stockage) et SHS (échantillonnage d'un niveau utile du noeud de stockage après déversement dans ce noeud des charges amplifiées par la structure d'amplification). Ces signaux sont émis successivement ligne par ligne au cours de la lecture.

Les lignes TR1 et TR2 représentent les impulsions appliquées respectivement aux grilles TR1 et TR2. Le signal TR1 est appliqué globalement pour tous les pixels ; le signal TR2 est émis ligne par ligne.

Les lignes GA et GB représentent les durées pendant lesquelles de multiples alternances de potentiels hauts et bas sont appliqués aux grilles GA et GB de la structure d'amplification. Ces potentiels sont appliqués à tous les pixels de la matrice pour lesquels une amplification est souhaitée (par exemple tous les pixels de la matrice ou tous les pixels d'une région d'intérêt).

Le déroulement de la séquence pour la trame FR1 est le suivant :
- réinitialisation de la photodiode par le signal GR, la fin de cette réinitialisation constituant le début d'une période d'intégration pour tous les pixels ; la fin du signal GR détermine le début d'un temps d'intégration de charges Ti1 ; plus le signal GR est long, plus la durée d'intégration est courte, si on considère que la durée totale (constante) d'une trame périodique comprend d'abord une durée de réinitialisation globale puis une durée d'intégration Ti1 ;
- intégration de charges dans la photodiode
- ouverture de la première grille de transfert TR1 pour tous les pixels, vidant les charges de la photodiode sous la grille GA de la structure d'amplification à la fin de la durée d'intégration Ti1 ; c'est la fin de l'ouverture de la grille TR1 qui détermine la fin de la durée Ti1.

A partir de là commence l'intégration de charges de la trame suivante FR2 mais le traitement des signaux issus de la première trame continue par une amplification dans la structure d'amplification par application d'une alternance de potentiels sur les grilles GA et GB ; le nombre d'alternances est choisi pour multiplier le nombre d'électrons par un premier coefficient de multiplication k1.

Puis on effectue successivement ligne par ligne (une ligne Lₙ est représentée et une ligne suivante Lₙ₊₁ est évoquée) les opérations suivantes
- réinitialisation du potentiel du noeud de stockage 18 (signal RS) ;
- échantillonnage du niveau de potentiel réinitialisé du noeud de stockage, par le circuit d'échantillonnage placé en pied de colonne (signal SHR pour la ligne considérée) ;
- transfert de charges de la grille GB vers le noeud de stockage par la deuxième grille de transfert TR2 pour la ligne considérée ;
- échantillonnage du potentiel du noeud de stockage des pixels de la ligne considérée par le circuit d'échantillonnage en pied de colonne (signal SHS pour la ligne considérée) ;
- conversion analogique-numérique de la différence des deux échantillons.

Les quatre signaux consécutifs RS, SHR, TR2, SHS et la conversion analogique-numérique sont répétés pour chaque ligne pendant que se produit l'intégration de charges de la deuxième trame FR2.

La mesure effectuée est une mesure par double échantillonnage corrélé véritable, en ce sens que la valeur convertie est la différence entre un échantillon de potentiel pris juste après une réinitialisation du noeud de stockage et un échantillon de potentiel ultérieur pris après déversement de charges de la structure d'amplification vers le noeud de stockage.

En vision à bas niveau de luminance on appliquera un nombre N élevé d'alternances de potentiel. En vision à niveau moyen on appliquera un nombre plus réduit. En vision à niveau de luminance élevé on n'appliquera pas du tout d'alternances de potentiels opposés sur les grilles GA et GB.

Pour une image très contrastée (pixels très faiblement éclairés et pixels fortement éclairés dans la même image) on pourra utiliser deux coefficients différents k1 et k2 dans deux trames successives différentes FR1 et FR2 et sélectionner pour chaque pixel la trame qui donne la mesure la plus appropriée. Il faut alors deux trames pour obtenir une image complète. La durée d'intégration peut d'ailleurs être différente dans les deux trames : durée Ti1 dans les trames impaires, durée Ti2 dans les trames paires. De préférence la durée la plus courte, par exemple Ti1, correspond à la trame qui a le plus faible coefficient d'amplification, par exemple k1.

Il faut que la valeur numérique établie par le convertisseur analogique-numérique pour un pixel mesuré avec le coefficient le plus faible soit multipliée par le rapport k2/k1 entre le coefficient le plus fort et le coefficient le plus faible, pour rapporter à la même échelle les mesures faites dans des conditions différentes. Il faut aussi que la valeur mesurée avec la plus faible durée d'intégration (par exemple Ti1) soit multipliée par le rapport Ti2/Ti1.

Un inconvénient de l'utilisation de deux trames avec deux coefficients d'amplification différents, que ce soit avec des temps d'intégration identiques ou des temps d'intégration différents, est le fait qu'il faut deux trames pour faire une seule image, ce qui ralentit la cadence de fourniture des images.

Dans un autre mode de fonctionnement pour la haute dynamique, on n'utilise qu'une trame, avec une durée d'intégration qui est divisée en deux parties ; chaque partie donne lieu à une intégration d'électrons et une amplification du nombre d'électrons, les coefficients d'amplification étant différents dans les deux parties. Les durées d'intégration des deux parties peuvent être identiques ou différentes. Le coefficient d'amplification le plus faible et la durée la plus courte sont utilisés de préférence pour la première durée d'intégration.

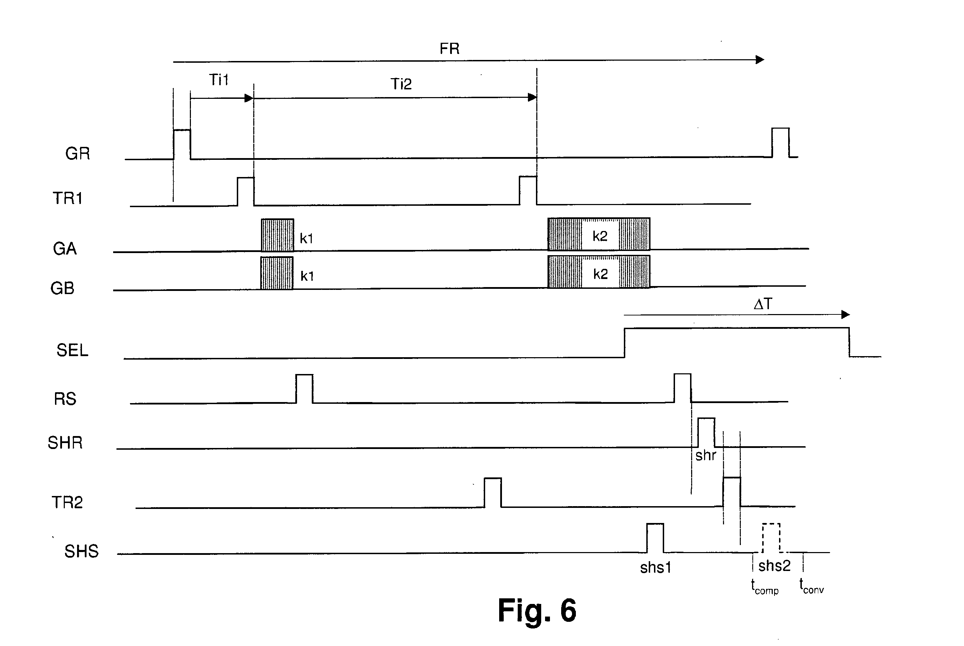

Le fonctionnement avec deux durées d'intégration est le suivant pour chaque ligne ; il est illustré par la figure 6 ; une seule trame FR est indiquée puisqu'une seule trame permet de recueillir une image complète ; seuls les signaux correspondants à une ligne de pixels sont représentés pour ne pas surcharger la figure :
- réinitialisation de la photodiode par un signal GR pour la ligne considérée, pour démarrer une période d'intégration de cette ligne ;
- intégration de charges dans la photodiode ;
- ouverture de la première grille de transfert TR1, vidant les charges de la photodiode dans la structure d'amplification, à la fin d'une première durée d'intégration Ti1 de préférence brève, c'est-à-dire inférieure ou très inférieure à la moitié de la durée totale d'intégration d'une trame ; la photodiode recommence à intégrer des charges dès que la grille se referme ;
- première amplification avec un premier coefficient d'amplification k1 faible ou même unitaire (pas d'amplification) ;
- réinitialisation du potentiel du noeud de stockage par un signal RS ;
- ouverture brève de la deuxième grille de transfert TR2 pour transférer les charges amplifiées par le coefficient k1 vers le noeud de stockage ; refermeture de cette grille ;
- ouverture de la première grille de transfert TR1, définissant la fin d'une deuxième durée d'intégration Ti2, la somme des durées Ti1 et Ti2 constituant la durée d'intégration totale de la trame ; les charges correspondant à la deuxième durée passent dans la structure d'amplification et vont être amplifiées avec un deuxième coefficient d'amplification k2 ;
- à la fin de la deuxième amplification et avant le transfert des charges amplifiées vers le noeud de stockage par la grille TR2, on fait dans l'ordre : un premier échantillonnage, par le signal shs1, dans le circuit de lecture, du niveau du noeud de stockage qui, à ce moment, correspond à la première intégration, amplifiée par le coefficient k1 ; puis une réinitialisation du noeud de stockage (RS) ; puis un deuxième échantillonnage, dans le circuit de lecture, du niveau de réinitialisation (shr) ;
- enfin, ouverture de la deuxième grille de transfert TR2, donc un transfert vers le noeud de stockage des charges de la deuxième durée d'intégration amplifiées par le deuxième coefficient d'amplification ; enfin un troisième échantillonnage, mais conditionnel et non systématique, shs2 du niveau du noeud de stockage ; le troisième échantillonnage, s'il est fait, vient remplacer le premier échantillonnage.

Le troisième échantillonnage n'est pas effectué si l'éclairement mesuré par le pixel, soit à la suite de la première durée d'intégration soit à la suite de la deuxième durée d'intégration, dépasse un seuil montrant un risque de saturation de la chaîne de mesure.

Si le troisième échantillonnage n'est pas effectué, on numérise alors la différence entre le premier échantillon et le deuxième échantillon. Cela revient à retenir le résultat de la première intégration seulement.

Dans le cas contraire, si le troisième échantillonnage est effectué (pas de risque de saturation), le troisième échantillon se substitue au premier. On numérise alors la différence entre le troisième et le deuxième échantillon, ce qui revient à mesurer le résultat de l'intégration pendant la deuxième durée seulement. Cette différence est une mesure par double échantillonnage corrélé véritable, contrairement à la numérisation de la différence entre les deux premiers échantillons.

La valeur numérique obtenue dans le premier cas (pas de troisième échantillonnage) est multipliée par un facteur qui est le rapport (k2.Ti2/k1.Ti1) pour être référencée par rapport à la même échelle que dans le deuxième cas (avec troisième échantillonnage).

Pour effectuer un troisième échantillonnage conditionnel, on peut tester le niveau de potentiel du noeud de stockage à la fin de la deuxième mesure, à un instant t_{comp} juste avant le moment du troisième échantillonnage conditionnel, ou tester le niveau de potentiel du noeud de stockage à la fin de la première mesure.

Le circuit de lecture comprend un circuit de test à cet effet qui agit pour autoriser ou non la production du signal shs2. Ce circuit mémorise par ailleurs le résultat du test et ce résultat est utilisé pour décider si on doit ou non multiplier le résultat de la mesure différentielle par un facteur multiplicatif (k2.Ti2/k1.Ti1).

Tous les signaux représentés à la figure 6 pour une ligne doivent être répétés à l'identique mais décalés d'une durée ΔT pour la ligne suivante et ainsi de suite (fonctionnement dit en "rolling shutter"). La durée ΔT est la durée nécessaire pour effectuer les trois échantillonnages et effectuer la conversion analogique-numérique des différences d'échantillons.

On notera que le temps d'amplification par les grilles GA et GB doit être limité à la différente entre la durée d'une période d'intégration et la durée nécessaire pour lire toutes les lignes puisque celles-ci sont lues successivement. Par exemple, si la durée d'intégration est de 15 millisecondes et si la durée nécessaire pour la lecture est d'environ 5 millisecondes (5 microsecondes par ligne pour 1024 lignes par exemple), le temps d'amplification doit être limité à 10 millisecondes.

Le test d'échantillonnage conditionnel est effectué dans le circuit de lecture. Dans un exemple, un comparateur à seuil compare le niveau du potentiel du noeud de stockage (présent sur le conducteur de colonne) juste après le deuxième transfert par la grille TR2 et autorise ou interdit le troisième échantillonnage. Dans un autre exemple, applicable notamment lorsque la première durée d'intégration Ti1 est la plus courte, le convertisseur analogique-numérique est un convertisseur à rampe qui effectue une conversion provisoire rapide sur le résultat du premier échantillonnage ; selon le résultat de cette conversion provisoire rapide, on autorise ou non l'échantillonnage conditionnel, et dans tous les cas le convertisseur recommence une conversion définitive. La conversion provisoire peut consister à observer la sortie d'un comparateur d'entrée du convertisseur ; le comparateur reçoit sur ses deux entrées les échantillons de signal utile et de niveau de réinitialisation ; une courte rampe de tension linéaire de durée prédéfinie est appliquée à l'entrée de signal utile et s'ajoute au signal utile ; le comparateur bascule dès que la tension différentielle entre ses entrées devient nulle. Le comparateur bascule avant la fin de la rampe si l'éclairement est faible, il ne bascule pas si l'éclairement est fort.

Si on utilise dans le circuit de lecture trois capacités d'échantillonnage au lieu de deux, on peut faire un échantillonnage shs2 systématique (non-conditionnel). On stocke dans les trois capacités respectivement un niveau de réinitialisation, un niveau de mesure correspondant à la première durée d'intégration avec le premier coefficient, et un niveau de mesure correspondant à la deuxième durée. On effectue alors une conversion analogique-numérique de la différence entre les tensions dans la deuxième et la première capacité, ou bien la conversion de la différence entre les tensions dans la troisième et la deuxième capacité. La valeur convertie peut alors être une valeur résultant d'un double échantillonnage corrélé véritable, à condition qu'on fasse pour chaque ligne les opérations dans l'ordre suivant :
- réinitialisation du niveau du noeud de stockage ;
- échantillonnage de ce niveau dans la première capacité ;
- transfert du résultat de la première intégration (amplifiée par la structure d'amplification) dans le noeud de stockage puis transfert de la photodiode vers la structure d'amplification à la fin de la deuxième durée d'intégration Ti2 ;
- échantillonnage du niveau du noeud de stockage dans la deuxième capacité ;
- transfert du résultat de la deuxième intégration amplifiée vers le noeud de stockage sans réinitialisation préalable de ce dernier ;
- échantillonnage du niveau dans la troisième capacité.

Dans ce mode de fonctionnement, on a de la même manière que précédemment une condition de niveau d'éclairement pour sélectionner la conversion qu'on doit faire. La condition est la même que précédemment ; elle n'agit non pas sur l'autorisation d'un échantillonnage shs2 mais sur le choix des échantillons (premier ou troisième ) qui seront utilisés pour la conversion.

Enfin, dans une réalisation, on prévoit que les grilles GA des pixels d'une même ligne sont commandées par un conducteur en ligne et les grilles GB des pixels d'une même colonne sont commandées par un conducteur en colonne. L'amplification par alternance de potentiels ne se produit que si à la fois les grilles GA et les grilles GB reçoivent des potentiels en alternance périodique. On peut prévoir des moyens pour sélectionner une partie seulement des lignes de pixels pour appliquer à leurs grilles GA une alternance de potentiels et des moyens pour sélectionner une partie seulement des colonnes de pixels pour appliquer à leurs grilles GB une autre alternance de potentiels, les deux alternances se combinant pour créer une alternance de champs électriques de sens opposés. Dans ce cas, seuls les pixels aux intersections de ces lignes et colonnes subiront une amplification par multiplication d'électrons dans le pixel. On peut donc sélectionner une région d'intérêt dans l'image, notamment une région sombre, pour lui appliquer une amplification par multiplication d'électrons sans l'appliquer aux autres régions.

Les possibilités offertes par cette sélection de région d'intérêt se combinent avec les possibilités offertes par la sélection de deux coefficients de multiplication différents pour une même prise d'image, ces deux coefficients pouvant être appliqués dans la même région d'intérêt.

## Revendications

1. Capteur d'image à pixels actifs formé dans un substrat semiconducteur (10), chaque pixel comprenant, à la surface d'une couche active semiconductrice (12), une région de photodiode (PHD), un noeud de stockage de charges (18), un transistor de lecture des charges stockées dans le noeud de stockage, un transistor de réinitialisation du potentiel du noeud de stockage, et une structure de transfert pour transférer des charges de la photodiode vers le noeud de stockage après une durée d'intégration de charges générées par la lumière dans la photodiode, la structure de transfert comprend une première grille de transfert (TR1) adjacente à la photodiode, une deuxième grille de transfert (TR2) adjacente au noeud de stockage, et une structure d'amplification (AMP) située entre la première et la deuxième grille de transfert et comprenant deux grilles d'accélération séparées (GA et GB) **caractérisé par** une région de diode intermédiaire (DI) à potentiel superficiel fixe située entre les deux grilles d'accélération, des moyens pour appliquer d'abord à la première grille de transfert (TR1) une première impulsion de transfert permettant le transfert de charges de la grille de transfert vers au moins une première grille d'accélération (GA), des moyens pour appliquer ensuite aux grilles d'accélération une succession d'alternances de potentiels haut et bas permettant des transferts successifs de charges d'une grille d'accélération à l'autre à travers la région de diode intermédiaire, et des moyens pour appliquer ensuite à la deuxième grille de transfert (TR2) une deuxième impulsion de transfert permettant le transfert de charges des grilles d'accélération vers le noeud de stockage.

2. Capteur selon la revendication 1, **caractérisé en ce que** la région de diode intermédiaire est une diode pinned ayant un potentiel de surface fixé par rapport à un potentiel de référence, et **en ce que** les alternances de potentiels opposés sont un potentiel haut et un potentiel bas tels que le potentiel sous une grille alterne entre un niveau plus élevé et un niveau moins élevé que le potentiel fixe de surface.

3. Capteur selon l'une des revendications 1 et 2, **caractérisé en ce que** le substrat semiconducteur comporte une couche active semiconductrice de type P qui est maintenue au potentiel de référence, et la diode intermédiaire comprend une région diffusée de type N dans cette couche, cette région étant recouverte d'une région superficielle de type P reliée au potentiel de la couche active.

4. Capteur selon l'une des revendications 1 à 3, **caractérisé en ce qu'**il comporte des moyens pour appliquer une amplification avec un facteur différent pendant les trames paires et les trames impaires.

5. Capteur selon l'une des revendications 1 à 3, **caractérisé en ce qu'**il comporte des moyens pour effectuer successivement au cours d'une même trame une mesure pour une première durée d'intégration et une mesure pour une deuxième durée d'intégration, et des moyens pour sélectionner l'une des deux mesures en fonction d'un niveau de potentiel sur le noeud de stockage après une amplification de l'intégration faite pendant la première durée ou après une amplification de l'intégration faite pendant la deuxième durée.

## Patentansprüche

1. Bildsensor mit aktiven Pixeln, der in einem Halbleitersubstrat (10) ausgebildet ist, wobei jedes Pixel auf der Oberfläche einer aktiven Halbleiterschicht (12) eine Fotodiodenregion (PHD), einen Ladungsspeicherknoten (18), einen Transistor zum Lesen von in dem Speicherknoten gespeicherten Ladungen, einen Transistor zum Reinitialisieren des Potentials des Speicherknotens und eine Übertragungsstruktur zum Übertragen von Ladungen der Fotodiode zu dem Speicherknoten nach einer Integrationsdauer von durch das Licht in der Fotodiode erzeugten Ladungen umfasst, wobei die Übertragungsstruktur ein erstes Übertragungsgitter (TR1) neben der Fotodiode, ein zweites Übertragungsgitter (TR2) neben dem Speicherknoten und eine Verstärkungsstruktur (AMP) umfasst, die sich zwischen dem ersten und dem zweiten Übertragungsgitter befindet und zwei getrennte Beschleunigungsgitter (GA und GB) umfasst, **gekennzeichnet durch** eine Zwischendiodenregion (DI) mit festem Oberflächenpotential, die sich zwischen den beiden Beschleunigungsgittern befindet, Mittel, um zunächst einen ersten Übertragungsimpuls an das erste Übertragungsgitter (TR1) anzulegen, der eine Übertragung von Ladungen des Übertragungsgitters zu wenigstens einem ersten Beschleunigungsgitter (GA) zulässt, Mittel zum anschließenden Anlegen einer abwechselnden Folge von hohen und tiefen Potentialen an die Beschleunigungsgitter, um sukzessive Übertragungen von Ladungen eines Beschleunigungsgitters zum anderen **durch** die Zwischendiodenregion zuzulassen, und Mittel zum nachfolgenden Anlegen eines zweiten Übertragungsimpulses an das zweite Übertragungsgitter (TR2), so dass Ladungen von Beschleunigungsgittern zum Speicherknoten übertragen werden können.

2. Sensor nach Anspruch 1, **dadurch gekennzeichnet, dass** die Zwischendiodenregion eine gepinnte Diode mit einem festen Oberflächenpotential relativ zu einem Referenzpotential ist, und dadurch, dass die Abwechslung zwischen entgegengesetzten Potentialen ein hohes Potential und ein tiefes Potential ist, so dass das Potential unter einem Gitter zwischen einem höheren Pegel und einem tieferen Pegel abwechselt als das feste Oberflächenpotential.

3. Sensor nach einem der Ansprüche 1 und 2, **dadurch gekennzeichnet, dass** das Halbleitersubstrat eine aktive Halbleiterschicht des P-Typs umfasst, die auf dem Referenzpotential gehalten wird, und die Zwischendiode eine gestreute Region des N-Typs in dieser Schicht umfasst, wobei diese Region von einer Oberflächenregion des P-Typs bedeckt wird, die mit dem Potential der aktiven Schicht verbunden ist.

4. Sensor nach einem der Ansprüche 1 bis 3, **dadurch gekennzeichnet, dass** er Mittel zum Anwenden einer Verstärkung mit einem anderen Faktor während der geradzahligen Frames und der ungeradzahligen Frames umfasst.

5. Sensor nach einem der Ansprüche 1 bis 3, **dadurch gekennzeichnet, dass** er Mittel zum aufeinander folgenden Bewirken auf demselben Frame einer Messung für eine erste Integrationsdauer und einer Messung für eine zweite Integrationsdauer umfasst, sowie Mittel zum Auswählen von einer der zwei Messungen in Abhängigkeit von einem Potentialpegel am Speicherknoten nach einer Verstärkung der Integration, die während der ersten Dauer erfolgt, oder nach einer Verstärkung der Integration, die während der zweiten Dauer erfolgt.

## Claims

1. Active-pixel image sensor formed in a semiconductor substrate (10), each pixel comprising, at the surface of a semiconductor active layer (12), a photodiode region (PHD), a charge storage node (18), a read transistor for reading the charges stored in the storage node, a reset transistor for resetting the potential of the storage node, and a transfer structure for transferring charges from the photodiode to the storage node after a charge integration time for charges generated by the light in the photodiode, the transfer structure comprises a first transfer gate (TR1) adjacent to the photodiode, a second transfer gate (TR2) adjacent to the storage node, and an amplifying structure (AMP) located between the first and second transfer gates and comprising two separate accelerating gates (GA) and (GB), **characterized by** an intermediate diode region (DI) at a fixed surface potential, located between the two accelerating gates, means for firstly applying to the first transfer gate (TR1) a first transfer pulse for charge transfer from the transfer gate to at least one first accelerating gate (GA), means for then applying to the accelerating gates a succession of alternating high and low potentials for successive charge transfer from one accelerating gate to the other through the intermediate diode region, and means for then applying to the second transfer gate (TR2) a second transfer pulse for charge transfer from the accelerating gates to the storage node.

2. Sensor according to Claim 1, **characterized in that** the intermediate diode region is a pinned diode having a fixed surface potential with respect to a reference potential, and **in that** the alternations of opposed potentials are a high potential and a low potential such that the potential beneath a gate alternates between a higher level and a lower level than the fixed surface potential.

3. Sensor according to either of Claims 1 and 2, **characterized in that** the semiconductor substrate includes a p-type semiconductor active layer which is maintained at the reference potential, and the intermediate diode includes an N-type diffused region in said layer, this region being covered by a P-type surface region connected to the potential of the active layer.

4. Sensor according to one of Claims 1 to 3, **characterized in that** it includes means for applying a different amplification factor during the even frames and the odd frames.

5. Sensor according to one of Claims 1 to 3, **characterized in that** it includes means for carrying out in succession over the course of the same frame a measurement for a first integration time and a measurement for a second integration time, and means for selecting one of the two measurements according to a potential level on the storage node after an amplification of the integration performed over the first time or after an amplification of the integration performed over the second time.
